# FASCICULE DE BREVET EUROPEEN

(11) **EP 2 172 783 B1**
(45) Date de publication et mention de la délivrance du brevet: **24.06.2015**
(21) Numéro de dépôt: 09305931.9
(22) Date de dépôt: 01.10.2009
(51) Int. Cl.: G01P 3/487, G01P 3/488, G01P 21/02, G01D 5/14, G01R 33/07, G01D 5/244

(54) **Capteur de mouvement pour tachygraphe numérique et système comprenant un tel capteur**
Bewegungssensor für digitale Fahrtenschreiber und System mit einem solchen Sensor
Movement sensor for digital tachograph and system comprising the same

(30) Priorité: 06.10.2008 FR 0856760
(43) Date de publication de la demande: 07.04.2010
(73) Titulaire: ACTIA Automotive, 31432 Toulouse Cedex 4 (FR)
(72) Inventeur: KUNEGEL, Jacques, 31470, BONREPOS SUR AUSSONNELLE (FR); NARAT, Pierre, 31150, FENOUILLET (FR)
(74) Mandataire: Santarelli

(56) Documents cités:
- EP-A- 1 102 213
- US-A1- 2003 178 989

## Description

L'invention se rapporte à un capteur de mouvement pour tachygraphe et à un procédé de transmission de données par un tel capteur à un tachygraphe.

On entend par « données » les données comportant les informations représentatives du mouvement d'un véhicule.

On entend par tachygraphe un appareil électronique enregistreur de vitesse, de temps de conduite et d'activités (travail, repos...) installé dans un véhicule de transport routier.

Il arrive que les données (notamment les informations représentatives du mouvement) transmises par les capteurs aux tachygraphes soient faussées ou que la transmission de telles données soit arrêtée, notamment à cause de perturbations électromagnétiques parasites, brèves ou permanentes, telles que celles générées par un système de freinage électromagnétique d'un véhicule, ou bien encore celles générées par des chauffeurs de véhicule mal intentionnés, qui appliquent des champs magnétiques perturbateurs au voisinage du capteur, par exemple en approchant un aimant.

Il en résulte que les données délivrées par le tachygraphe sont parfois erronées.

On connaît du document FR 2 662 873 un capteur de vitesse à effet hall à détection différentielle qui comporte au moins deux sondes à effet Hall, espacées l'une de l'autre, et des moyens aptes à soumettre les sondes à un champ d'induction déterminé, en l'absence d'organe perturbateur (tel qu'une roue aimantée). Un tel capteur permet de contrôler les positions de véhicules et leurs déplacements, et sont conçus en particulier pour être utilisés directement pour une fabrication en série de capteurs comprenant un aimant assemblé. Toutefois, un tel document ne prévoit aucune solution technique au problème des perturbations électromagnétiques qui faussent les données délivrées par le tachygraphe.

On connaît par ailleurs du document FR 2 895 075 un capteur magnétique comportant des moyens permettant d'obtenir un signal franc, pour notamment délivrer des informations précises, ces moyens consistant en des moyens de correction de la valeur du champ magnétique sur un pôle d'une roue dentée magnétique qui est irrégulier, par exemple le pôle repérant le point mort haut d'allumage.

Aucun des documents FR 2 662 873 et FR 2 895 075 n'offre de solution technique permettant de pallier les arrêts de transmission de données (informations représentatives du mouvement) lors de perturbations électromagnétiques parasites de la vitesse.

Les documents US 2003/178989 et EP 1102213 décrivent d'autres capteurs de mouvement pour tachygraphe.

L'invention vise à proposer un nouveau capteur et un procédé mettant en oeuvre un tel capteur, permettant de délivrer des données même lorsque surviennent de telles perturbations parasites.

Dans un premier temps, l'invention concerne un capteur pour tachygraphe, ledit capteur comportant au moins une cellule sensible aux variations d'intensité d'un champ magnétique et alimentée en énergie électrique, ladite cellule étant associée à des moyens de calibration qui sont mis en oeuvre en réponse à sa mise sous tension, **caractérisé en ce qu'**il comporte des moyens de commande pour interrompre temporairement l'alimentation en énergie électrique de ladite cellule et pour remettre sous tension ladite cellule de manière à activer les moyens de calibration, en réponse à une détection d'une absence de transmission de données par ladite cellule pendant un intervalle de temps.

En effet, les capteurs (et donc la cellule) traditionnels sont usuellement alimentés en permanence et de ce fait, la calibration de la cellule s'effectue uniquement lors de l'installation du capteur sur le véhicule ou lors d'opérations de maintenance du véhicule. Par la suite, le capteur ne s'adapte plus aux variations importantes de son environnement magnétique, et peut perdre sa capacité à détecter de petites variations de champ magnétique indiquant que le véhicule se déplace.

Avec un capteur conforme à l'invention, tel que défini ci-dessus, la remise sous tension de la cellule implique une activation fréquente des moyens de calibration, sans que le tachygraphe (auquel le compteur est connecté) ne soit perturbé.

Cette activation permet une nouvelle calibration de la cellule en fonction d'une nouvelle intensité du champ magnétique environnant. La cellule peut ainsi de nouveau détecter les petites variations de champ magnétique générées par exemple par le mouvement de rotation d'une roue métallique dentée (polarisée (ou non), placée près de la cellule, ces petites variations ayant été rendues non significatives pour la cellule du fait de l'intervention du champ magnétique parasite beaucoup plus important.

Le capteur selon l'invention peut également comporter les caractéristiques suivantes, prises séparément ou en combinaison :
- la cellule est une cellule à effet Hall, comportant ou non un aimant permanent,
- les moyens de calibration sont incorporés dans la cellule à effet Hall,
- le capteur comporte un microcontrôleur de transmission sécurisée de données par la cellule au tachygraphe,
- le microcontrôleur de transmission sécurisée de données et les moyens de commande sont incorporés dans un même composant électronique,
- les moyens de commande sont placés à distance de la cellule dans le capteur, ou dans le tachygraphe connecté au capteur.

Par ailleurs, l'invention concerne un procédé de transmission d'informations représentatives du mouvement d'un véhicule par un capteur à un tachygraphe comportant au moins une cellule sensible aux variations d'intensité d'un champ magnétique, ladite cellule étant alimentée en énergie par ledit tachygraphe et étant associée :
- à des moyens de calibration qui sont mis en oeuvre lors de sa mise sous tension,
   - et à des moyens de commande pour activer lesdits moyens de calibration, ledit procédé comportant les étapes suivantes :
      - détection, par lesdits moyens de commande, d'une absence de transmission d'informations indiquant le mouvement du véhicule par ladite cellule pendant un premier intervalle de temps ;
      - commande, par lesdits moyens de commande, de l'interruption de l'alimentation en énergie de ladite cellule pendant un second intervalle de temps ;
      - et commande, par lesdits moyens de commande, de la remise sous tension de ladite cellule à l'issue dudit second intervalle de temps.

Suivant des modes de mise en oeuvre conformes à l'invention, le procédé comporte les caractéristiques suivantes, prises séparément ou en combinaison :
- le premier intervalle de temps est compris entre 100 ms et 10s :
- le second intervalle de temps est compris entre 1 ms à 100 ms ;
- le procédé comprend une étape d'attente pendant un troisième intervalle de temps après la remise sous tension de la cellule à l'issue du second intervalle de temps ;
- le troisième intervalle de temps est sensiblement égal à 510 µs ;
- lesdits moyens de commande comprennent une mémoire pour mémoriser lesdites informations transmises par la cellule et les moyens de commande transmettent les informations mémorisées.

Ce dernier mode de mise en oeuvre peut, par exemple, assurer une transmission d'informations mémorisées pendant un certain intervalle de temps, tel que l'un ou l'autre de ceux exposés ci-dessus.

L'invention sera davantage comprise à la lumière de l'exemple de réalisation qui va maintenant être présenté, en faisant référence aux figures annexées parmi lesquelles :
- la figure 1 est une vue de côté montrant partiellement un capteur selon l'invention ;
- la figure 2 est une représentation schématique d'un capteur selon l'invention, comprenant une cellule et un microcontrôleur constituant les moyens de commande selon l'invention, le capteur étant associé à un tachygraphe et transmettant des données au tachygraphe ;
- la figure 3 est une représentation schématique du capteur et du tachygraphe de la figure 2, la cellule ne transmettant plus de signal au microcontrôleur ;
- la figure 4 est une représentation schématique du capteur et du tachygraphe de la figure 2, mettant en oeuvre quelques étapes du procédé selon l'invention ;
- la figure 5 est une représentation schématique du capteur et du tachygraphe de la figure 2, mettant en oeuvre quelques autres étapes du procédé selon l'invention ;
- la figure 6A montre le champ magnétique détecté par la cellule et le signal de sortie de la cellule en absence de champ perturbé ;
- la figure 6B montre le champ magnétique détecté par la cellule et le signal de sortie de la cellule en présence d'un champ perturbé et avant autocalibration ;
- la figure 7 montre le champ magnétique détecté par la cellule et le signal de sortie de la cellule en présence d'un champ perturbateur et après autocalibration.

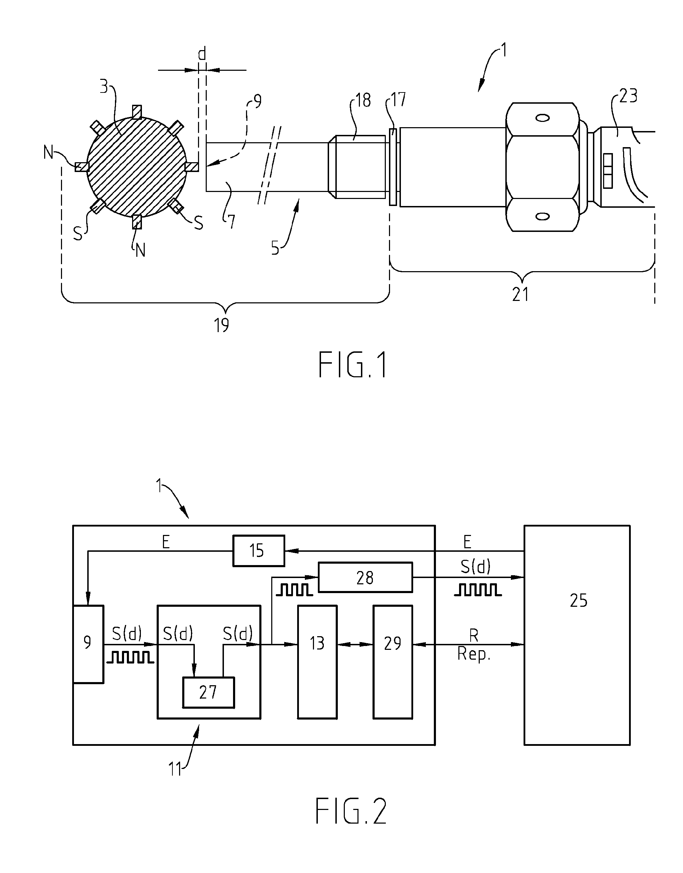

La figure 1 schématise un capteur 1 selon l'invention positionné devant une roue 3 pourvue ou non sur sa circonférence de pôles Nord N et de pôles Sud S alternés.

La capteur 1 présente une partie cylindrique 5 comprenant près de son extrémité 7 une cellule à effet Hall 9 disposée en face de la roue. Une distance déterminée d permet de laisser un espace entre l'extrémité du capteur et les dents qui défilent devant lorsque la roue est animée d'un mouvement de rotation, quand le véhicule se déplace.

La cellule 9 est une cellule à effet Hall qui comporte un élément sensible au changement d'intensité d'un champ magnétique à proximité duquel elle est placée. Elle peut être associée ou non à un aimant permanent.

La cellule 9 à effet Hall comporte également un circuit électronique comprenant des moyens d'autocalibration.

Les moyens d'autocalibration permettent à la cellule de repérer les valeurs extrêmes de l'intensité du champ magnétique à proximité duquel elle est placée, et de générer des signaux à chaque fois que l'une ou l'autre des valeurs extrêmes est proche d'être atteinte par le champ.

Ces valeurs extrêmes sont en fonctionnement normal (c'est-à-dire en l'absence de perturbation) celles du champ magnétique généré par les dents de la roue 3 et captées par la cellule 9.

La partie cylindrique 5 du capteur comporte également d'autres composants électroniques qui seront exposés et détaillés par la suite, notamment un premier microcontrôleur 11 constituant des moyens de commande selon l'invention, un second microcontrôleur 13 et des moyens 15 de contrôle de l'alimentation en énergie de la cellule 9.

Dans le cadre de cet exemple, le premier microcontrôleur 11 est placé à distance de la cellule 9 dans le capteur 1 pour qu'il ne soit pas endommagé ou perturbé par des températures trop élevées à l'extrémité du capteur.

La partie cylindrique 5 du capteur et la roue 3 sont enfermées dans une boîte de vitesses de véhicule, de manière en soi connue. Un filetage 18 permet de visser le capteur dans la boîte de vitesses.

Le capteur peut comporter également une rondelle 17 permettant le serrage du capteur ainsi vissé. Il comporte une partie 21 qui se trouve en dehors de la boîte de vitesses et qui présente un connecteur 23 pour relier le capteur 1, au moyen d'un câble (non représenté), à un tachygraphe 25 embarqué dans le véhicule.

On va maintenant s'intéresser aux composants du capteur selon l'invention et à leur mode de fonctionnement en faisant référence aux figures 2 à 5.

La figure 2 illustre de manière schématique le capteur 1 selon l'invention et le tachygraphe 25 auquel il est relié.

Les flèches montrent les divers échanges de signaux ou de données électroniques entre les composants du capteur et le tachygraphe 25 embarqué.

La cellule 9 est alimentée en énergie par le tachygraphe 25. Cette alimentation est illustrée par les flèches portant la référence E.

Comme le montre la figure 1, l'alimentation en énergie E est contrôlée en amont de la cellule par les moyens 15.

Les moyens 15 consistent en un ou plusieurs composants électroniques qui autorisent ou non l'alimentation en énergie E de la cellule en fonction des instructions de commande qu'ils reçoivent du microcontrôleur 11. La sortie de la cellule 9 change d'état à chaque fois qu'elle repère les valeurs extrêmes atteintes par le champ magnétique généré par la roue 3. Ainsi, un signal S(d) à deux états (haut, bas) est fourni au microcontrôleur 11. Ces états peuvent être mémorisés dans une mémoire 27 que comporte le microcontrôleur 11, et transmis d'une part vers une interface de sortie 28 vers le tachygraphe 25, d'autre part au second microcontrôleur 13 qui compte les changements d'état et en transmet le nombre, à son tour, au tachygraphe 25 dans des données encodées, comme expliqué ci-après.

Afin d'assurer une sécurité dans la transmission de données entre le tachygraphe et 25 et le capteur 1, de façon connue, le tachygraphe 25 envoie régulièrement des requêtes R au capteur 1. Ces requêtes R sont des interrogations que traite le microcontrôleur 13, et la réponse Rep transmise par le microcontrôleur 13 permet de vérifier qu'il n'y a aucune tentative de fraude. Une interface d'entrée/sortie 29 permet la mise en forme du signal transitant sur la ligne de communication.

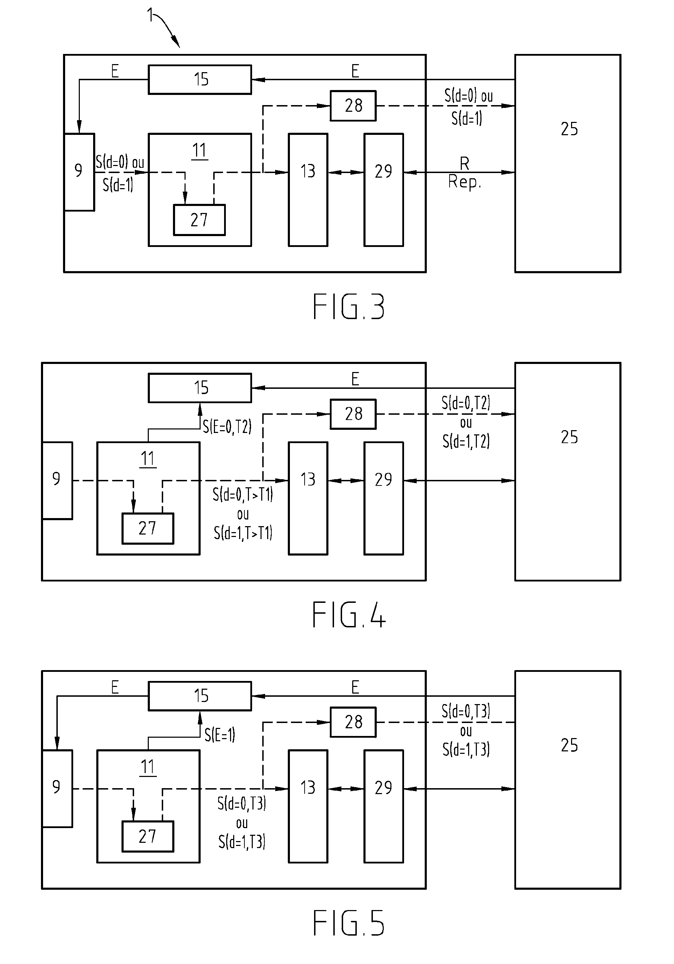

La figure 3 montre schématiquement les échanges entre les divers composants du capteur selon l'invention et le tachygraphe au moment où le signal de sortie S(d) de la cellule à effet Hall 9 ne change pas d'état.

Un tel cas se produit quand le véhicule est à l'arrêt. En effet, quand le véhicule est à l'arrêt, la roue 3 ne tourne plus, et l'intensité du champ magnétique vue ne varie plus.

Un tel cas peut toutefois se produire dans d'autres situations. Par exemple, lorsqu'un système de ralentissement du véhicule produisant un fort champ magnétique est activé, l'intensité de ce champ est supérieure à celle du champ généré par les dents de la roue 3 et le signal de sortie de la cellule 9 ne peut plus changer d'état, alors même que le véhicule roule.

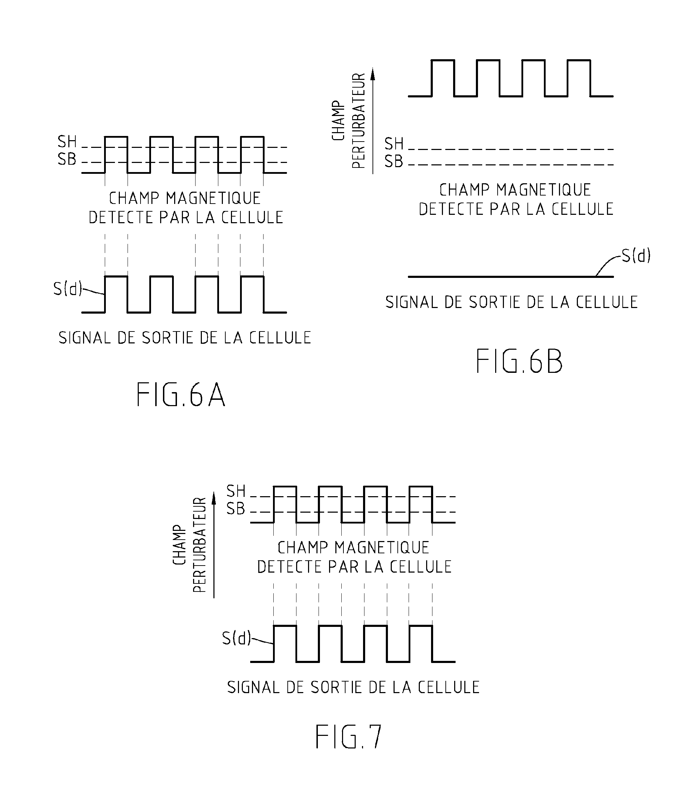

Ainsi, le fort champ magnétique généré par le système de ralentissement a rendu insensible la cellule 9 aux variations de champ magnétique générées par le passage des dents de la roue 3 devant la cellule 9, car les seuils de détection du signal (S(d) (si SH était le seuil de détection S(d) à l'état haut et SB le seuil de détection S(d) à l'état bas) ne sont plus franchis (voir figures 6A et 6B).

Certaines étapes du procédé selon l'invention ne seront toutefois mises en oeuvre que lorsque cette absence de changement d'état du signal sera détectée par le microcontrôleur 11 pendant un premier intervalle de temps prédéterminé T1.

L'absence de changement d'état du signal par le microcontrôleur 11 est repéré sur la figure 3 par une flèche tracée en traits pointillés et portant la référence S(d=0) ou S(d = 1).

Conformément à l'invention, le premier intervalle de temps T1 peut varier entre 10 ms et 10 s par pas de 100 ms. L'intervalle de temps T1 est de préférence fixé à 1 s dans le cadre du présent exemple de mise en oeuvre de l'invention. Mais cette durée peut varier en fonction de l'environnement du capteur (par exemple le type du véhicule).

La figure 3 montre que certains échanges perdurent toutefois entre certains composants, durant tout l'intervalle de temps entre le début d'absence de signal et le temps T1. Il s'agit de l'alimentation E de la cellule 9 en énergie, et des échanges de requêtes R et de réponses Rep entre le tachygraphe et le microcontrôleur 13 de sécurisation de données.

Quand l'intervalle de temps T1 s'est écoulé et que le microcontrôleur 11 ne détecte toujours pas de changement d'état du signal de la part de la cellule 9 (repéré par la flèche tracée en traits pointillés portant la référence S(d=0, T>T1) ou S(d = 1, T > T1), certaines étapes du procédé selon l'invention sont mises en oeuvre, comme l'illustre la figure 4.

Notamment, le microcontrôleur 11 envoie aux moyens de contrôle d'alimentation 15 un signal de commande S(E=0, T2) pour arrêter momentanément l'alimentation de la cellule 9 en énergie E pendant un second intervalle de temps T2.

Cet arrêt momentané de l'alimentation de la cellule en énergie doit être suffisamment long pour garantir la réinitialisation de la cellule 9 quand elle sera remise sous tension, c'est-à-dire l'activation des moyens d'autocalibration qu'elle comporte lors de sa remise sous tension. Les seuils de détection SH et SB du signal S(d) haut, bas seront alors recalculés par la cellule 9 (voir figure 7).

Conformément à l'invention, l'intervalle de temps T2 suffisant est compris sensiblement entre 1 ms et 100 ms par pas de 1 ms. Dans le cadre du présent exemple de mise en oeuvre de l'invention, on prévoit que l'intervalle de temps T2 soit sensiblement égal à 1 ms. Mais cette durée peur varier en fonction de la cellule utilisée.

Durant l'intervalle de temps T2, on prévoit de ne pas faire changer l'état du signal S(d) fourni au tachygraphe par le capteur 1. Aussi, le microcontrôleur 13 ne voit pas non plus de changement d'état (S(d) =0, T2 ou S(d) = 1, T2). Ceci est obtenu grâce à la mémorisation de S(d) dans la mémoire 27 du microcontrôleur 11. La communication entre le capteur 1 et le tachygraphe 25 n'est pas impactée par cette réinitialisation de la cellule 9.

Une fois que l'intervalle de temps T2 est écoulé, le microcontrôleur 11 adresse aux moyens de contrôle d'alimentation 15 un signal S(E=1) pour remettre sous tension la cellule 9 en autorisant de nouveau son alimentation en énergie E et activer les moyens d'autocalibration de la cellule.

Afin de garantir que cette autocalibration se déroule avec succès, pour assurer une détection de signal ou d'absence de signal correcte du microcontrôleur 11, on interdit tout changement de l'état du signal en provenance de la cellule 9 pendant un intervalle de temps supplémentaire, appelé intervalle de temps d'attente supplémentaire T3.

Cette étape est symbolisée par une flèche tracée en traits pointillés sur la figure 5, portant la référence S(d=0, T3 ou S(d) = 1, T3).

Durant cet intervalle de temps d'attente T3, l'état du signal fourni au tachygraphe 25 par le capteur 1 ne change pas. Aussi, le second microcontrôleur 13 ne voit pas non plus de changement d'état (S(d) = 0, T3) ou S(d) = 1, T3). Ceci est obtenu grâce à la mémorisation de S(d) dans la mémoire 27 du microcontrôleur 11. La communication le capteur 1 et le tachygraphe 25 n'est pas impactée par cette réinitialisation de la cellule 9.

On prévoit que ce troisième intervalle de temps d'attente T3 soit sensiblement égal à 510 µs. Mais cette durée peut varier en fonction de la cellule utilisée.

On comprend de ce qui précède comment le capteur et le procédé selon l'invention permettent de s'affranchir des problèmes liés à la présence d'un champ magnétique perturbateur dans la transmission de données entre le capteur et le tachygraphe.

Il devra toutefois être compris que l'invention n'est pas spécifiquement limitée aux modes de réalisation et de mise en oeuvre qui viennent d'être décrits.

En particulier, en variante de réalisation, il peut aisément être prévu de réaliser un seul microcontrôleur qui réalise à la fois la mise en oeuvre d'une fonction de transmission de données sécurisées entre le capteur et le tachygraphe, et celle de commander les moyens de contrôle 15 de l'alimentation de la cellule 9 en énergie E. Dans le cadre de ce mode de réalisation, les microcontrôleurs 11 et 13 ne constitueraient qu'un seul composant électronique à incorporer dans le capteur 1.

Par ailleurs, il devra être compris que l'invention s'applique également aux capteurs dont la cellule 9 ne comprendrait pas de moyens d'autocalibrage intégrés, mais serait associée à de tels moyens prévus dans le capteur.

## Revendications

1. Capteur de mouvement (1) pour tachygraphe (25), ledit capteur (1) comportant au moins une cellule (9) sensible aux variations d'intensité d'un champ magnétique et alimentée en énergie électrique (E), ladite cellule (9) étant associée à des moyens de calibration qui sont mis en oeuvre en réponse à sa mise sous tension, **caractérisé en ce que** ledit capteur comporte des moyens de commande (11) adaptés à interrompre temporairement l'alimentation en énergie électrique (E) de ladite cellule (9) et à remettre sous tension ladite cellule de manière à activer les moyens de calibration, en réponse à une détection d'une absence de transmission de données par ladite cellule (9) pendant un intervalle de temps (T1).

2. Capteur selon la revendication 1, **caractérisé en ce que** ladite cellule (9) est une cellule à effet Hall.

3. Capteur selon la revendication 2, **caractérisé en ce que** lesdits moyens de calibration sont incorporés dans ladite cellule à effet Hall (9).

4. Capteur selon l'une quelconque des revendications 1 à 3, **caractérisé en ce qu'**il comporte un microcontrôleur (13) de transmission sécurisée de données par ladite cellule audit tachygraphe.

5. Capteur selon la revendication 4, **caractérisé en ce que** ledit microcontrôleur de transmission sécurisée de données (13) et lesdits moyens de commande (11) sont incorporés dans un même composant électronique.

6. Capteur selon l'une quelconque des revendications 1 à 5, **caractérisé en ce que** lesdits moyens de commande (11) sont placés à distance de ladite cellule (9) dans ledit capteur (1).

7. Procédé de transmission d'informations représentatives du mouvement d'un véhicule par un capteur (1) à un tachygraphe (25) comportant au moins une cellule (9) sensible aux variations d'intensité d'un champ magnétique, ladite cellule (9) étant alimentée en énergie par ledit tachygraphe et étant associée :
- à des moyens de calibration qui sont mis en oeuvre lors de sa mise sous tension,
- et à des moyens de commande (11) pour activer lesdits moyens de calibration,
ledit procédé comportant les étapes suivantes :
- détection (S (d=0)), par lesdits moyens de commande (11), d'une absence de transmission d'informations indiquant le mouvement du véhicule (S (d=0)) par ladite cellule (9) pendant un premier intervalle de temps (T1) ;
- commande (S(E=0, T2)), par lesdits moyens de commande (11), de l'interruption de l'alimentation en énergie de ladite cellule (9) pendant un second intervalle de temps prédéterminé (T2),
- et commande (S(E=1)), par lesdits moyens de commande (11), de la remise sous tension de ladite cellule (9) à l'issue dudit second intervalle de temps (T2).

8. Procédé selon la revendication 7, **caractérisé en ce que** ledit premier intervalle de temps (T1) est compris entre 100 ms et 10s.

9. Procédé selon l'une quelconque des revendications 7 ou 8, **caractérisé en ce que** ledit second intervalle de temps (T2) est compris entre 1 ms à 100 ms.

10. Procédé selon l'une quelconque des revendications 7 à 9, **caractérisé en ce qu'**il comprend une étape d'attente pendant un troisième intervalle de temps (T3) après la remise sous tension de la cellule (9) à l'issue dudit second intervalle de temps (T2).

11. Procédé selon la revendication 10, **caractérisé en ce que** ledit troisième intervalle de temps (T3) est sensiblement égal à 510 µs.

12. Procédé selon l'une quelconque des revendications 7 à 11, **caractérisé en ce que** lesdits moyens de commande (11) comprennent une mémoire (27) pour mémoriser lesdites informations transmises par la cellule (9) et **en ce que** lesdits moyens de commande (11) transmettent lesdites informations mémorisées.

## Patentansprüche

1. Bewegungssensor (1) für Fahrtenschreiber (25), wobei der Sensor (1) zumindest eine Zelle (9) aufweist, die gegenüber Schwankungen in der Stärke eines Magnetfeldes empfindlich ist und mit elektrischer Energie (E) versorgt wird, wobei der Zelle (9) Kalibrierungsmittel zugeordnet sind, die in Reaktion auf das Anlegen einer Spannung an die Zelle betätigt werden,
**dadurch gekennzeichnet, dass**
der Sensor Steuermittel (11) aufweist, die dazu geeignet sind, die Versorgung der Zelle (9) mit elektrischer Energie (E) vorübergehend zu unterbrechen und wieder eine Spannung an die Zelle anzulegen, so dass die Kalibrierungsmittel aktiviert werden, und zwar in Reaktion auf eine Erfassung eines Ausbleibens der Übertragung von Daten über die Zelle (9) für ein Zeitintervall (T1).

2. Sensor nach Anspruch 1,
**dadurch gekennzeichnet, dass**
die Zelle (9) eine Zelle mit Hall-Effekt ist.

3. Sensor nach Anspruch 2,
**dadurch gekennzeichnet, dass**
die Kalibrierungsmittel der Hall-Effekt-Zelle (9) eingegliedert sind.

4. Sensor nach einem der Ansprüche 1 bis 3,
**dadurch gekennzeichnet, dass**
er einen Mikrokontroller (13) zum sicheren Übertragen von Daten über die Zelle an den Fahrtenschreiber aufweist.

5. Sensor nach Anspruch 4,
**dadurch gekennzeichnet, dass**
der Mikrokontroller (13) zum sicheren Übertragen von Daten und die Steuermittel (11) einem gleichen elektronischen Bauteil eingegliedert sind.

6. Sensor nach einem der Ansprüche 1 bis 5,
**dadurch gekennzeichnet, dass**
die Steuermittel (11) mit Abstand von der Zelle (9) in dem Sensor (1) angeordnet sind.

7. Verfahren zum Übertragen von für die Bewegung eines Fahrzeugs repräsentativen Informationen zu einem Fahrtenschreiber (25) über einen Sensor (1), der zumindest eine Zelle (9) aufweist, die gegenüber den Schwankungen in der Stärke eines Magnetfeldes empfindlich ist, wobei die Zelle (9) über den Fahrtenschreiber mit Energie versorgt wird und wobei ihr zugeordnet sind:
- Kalibrierungsmittel, die beim Anlegen einer Spannung an die Zelle betätigt werden,
- und Steuermittel (11), um die Kalibrierungsmittel zu aktivieren,
wobei das Verfahren die nachfolgenden Schritte umfasst:
- Erfassen (S (d = 0)) eines Ausbleibens der Übertragung von Informationen bezüglich der Bewegung des Fahrzeugs (S (d = 0)) über die Zelle (9) für ein erstes Zeitintervall (T1) mittels der Steuermittel (11),
- Steuern (S (E = 0, T2)) der Unterbrechung der Energieversorgung der Zelle (9) für ein zweites vorbestimmtes Zeitintervall (T2) mittels der Steuermittel (11), und
- Steuern (S (E = 1)) des Wiederanlegens einer Spannung an die Zelle (9) am Ende des zweiten Zeitintervalls (T2) mittels der Steuermittel (11).

8. Verfahren nach Anspruch 7,
**dadurch gekennzeichnet, dass** das erste Zeitintervall (T1) zwischen 100 ms und 10 s beträgt.

9. Verfahren nach einem der Ansprüche 7 oder 8,
**dadurch gekennzeichnet, dass** das zweite Zeitintervall (T2) zwischen 1 ms und 100 ms beträgt.

10. Verfahren nach einem der Ansprüche 7 bis 9,
**dadurch gekennzeichnet, dass** es einen Schritt des Abwartens eines dritten Zeitintervalls (T3) nach dem Wiederanlegen einer Spannung an die Zelle (9) am Ende des zweiten Zeitintervalls (T2) umfasst.

11. Verfahren nach Anspruch 10,
**dadurch gekennzeichnet, dass** das dritte Zeitintervall (T3) im Wesentlichen gleich 510 µs ist.

12. Verfahren nach einem der Ansprüche 7 bis 11,
**dadurch gekennzeichnet, dass** die Steuermittel (11) einen Speicher (27) zum Speichern der über die Zelle (9) übertragenen Informationen aufweisen und dass die Steuermittel (11) die gespeicherten Informationen übertragen.

## Claims

1. A motion sensor (1) for a tachograph (25), said sensor (1) comprising at least one cell (9) sensitive to the variations in intensity of a magnetic field and supplied with electrical energy (E), said cell (9) being associated with calibration means which are implemented in response to its powering on, **characterized in that** said sensor comprises control means (11) adapted to temporarily interrupt the supply in electrical energy (E) of said cell (9) and to power on again said cell so as to activate the calibration means, in response to a detection of a lack of sending of data by said cell (9) for a time interval (T1).

2. A sensor according to claim 1, **characterized in that** said cell (9) is a Hall effect cell.

3. A sensor according to claim 2, **characterized in that** said calibration means are incorporated in said Hall effect cell (9).

4. A sensor according to any one of claims 1 to 3, **characterized in that** it comprises a microcontroller (13) for secure sending of data by said cell to said tachograph.

5. A sensor according to claim 4, **characterized in that** said microcontroller (13) for secure sending of data and said control means (11) are incorporated into the same electronic component.

6. A sensor according to any one of claims 1 to 5, **characterized in that** said control means (11) are placed away from said cell (9) in said sensor (1).

7. A method of sending information representing the motion of a vehicle by a sensor (1) to a tachograph (25) comprising at least one cell (9) sensitive to the variations in intensity of a magnetic field, said cell (9) being supplied in energy by said tachograph and being associated:
- with calibration means which are implemented when it is powered on,
- and control means (11) to activate said calibration means,
said method comprising the following steps:
- detecting (S (d=0)), by said control means (11), a lack of sending of information indicating the motion of the vehicle (S (d=0)) by said cell (9) during a first time interval (T1);
- actuating (S(E=0, T2)), by said control means (11), the interruption in the energy supply of said cell (9) for a second, predetermined, time interval (T2),
- and actuating (S(E=1)), by said control means (11), the powering on again of said cell (9) at the end of said second, predetermined, time interval (T2).

8. A method according to claim 7, **characterized in that** said first time interval (T1) is comprised between 100 ms and 10s.

9. A method according to any one of claims 7 or 8, **characterized in that** said second time interval (T2) is comprised between 1 ms and 100 ms.

10. A method according to any one of claims 7 to 9, **characterized in that** it comprises a step of waiting over a third time interval (T3) after the powering on again of said cell (9) at the end of said second time interval (T2).

11. A method according to claim 10, **characterized in that** said third time interval (T3) is substantially equal to 510 µs.

12. A method according to any one of claims 7 to 11, **characterized in that** said control means (11) comprise a memory (27) to store said information sent by the cell (9) and **in that** said control means (11) send said stored information.
